## Europäisches Patentamt

## European Patent Office

## Office européen des brevets

(19)

(11) Veröffentlichungsnummer: **0 416 477 A2**

# EUROPÄISCHE PATENTANMELDUNG

(12)

(21) Anmeldenummer: 90116735.3

(22) Anmeldetag: 31.08.90

(51) Int. Cl.5: **H01S  3/19**

(30) Priorität: 04.09.89 DE 3929312

(43) Veröffentlichungstag der Anmeldung:
13.03.91 Patentblatt  91/11

(84) Benannte Vertragsstaaten:
**DE FR GB IT NL**

(71) Anmelder: **Standard Elektrik Lorenz Aktiengesellschaft**
**Lorenzstrasse 10**
**W-7000 Stuttgart 40(DE)**

(84) DE

Anmelder: **ALCATEL N.V.**
**Strawinskylaan 341 (World Trade Center)**
**NL-1077 XX Amsterdam(NL)**

(84) **FR GB IT NL**

(72) Erfinder: **Wünstel, Klaus, Dr.**
**Stiegelstrasse 18**
**W-7141 Schwieberdingen(DE)**
Erfinder: **Weinmann, Reinhold**
**Bauernackerweg 8**
**W-7300 Esslingen(DE)**

(74) Vertreter: **Gähr, Hans-Dieter, Dipl.-Ing. (FH) et al**
**Standard Elektrik Lorenz AG Patent- und Lizenzwesen Postfach 30 09 29**
**W-7000 Stuttgart 30(DE)**

(54) **Halbleiterlaser.**

(57) Es ist bekannt, Halbleiterlaser, die eine laseraktive Zone (2) und weitere Schichten in Form einer Mesa aufweisen, seitlich mit einer semiisolierenden Schicht (4) zu versehen, um im Betrieb des Halbleiterlasers den Fluß des Stromes auf die Mesa einzugrenzen.

Erfindungsgemäß sind oberhalb oder unterhalb der semiisolierenden Schicht mindestens eine n- (6) und eine p-leitende Schicht (5) vorhanden.

FIG.1

# HALBLEITERLASER

Die Erfindung betrifft einen Halbleiterlaser, der auf einem Halbleitersubstrat wenigstens eine, sich über einen Teil der Oberfläche des Halbleitersubstrats erstreckende laseraktive Zone und seitlich der laseraktiven Zone wenigstens eine semiisolierende Schicht aufweist.

Aus Appl. Phys. Lett. 48 (1986), S. 1572-1573 ist ein DCPBH (Double Channel Planar Heterostructure)-Halbleiterlaser bekannt, der auf einem n-InP-Substrat vier epitaktisch aufgewachsene Schichten besitzt: eine n-InP-Schicht, die als Pufferschicht dient und das n-InP-Substrat in seiner Breite bedeckt, eine nicht dotierte InGaAsP-Schicht als laseraktive Zone, eine p-InP-Schicht als Wellenleiterzone und eine p-InGaAsP-Schicht als Kontaktschicht.

In die InGaAsP-, die p-InP- und die p-InGaAsP-Schichten sind zwei zueinander parallele Gräben hineingeätzt, so daß zwischen ihnen eine Mesa vorhanden ist. Die Gräben sind mit einer semiisolierenden Schicht ausgefüllt, die an ihren Längsseiten bis zur Höhe der Oberfläche der Kontaktschicht auf der Mesa heranragt. Oberhalb der Kontaktschicht weist die Mesa eine metallische Kontaktierung auf, an die, wenn der Halbleiterlaser betrieben wird, eine Spannung angelegt wird.

Semiisolierende Schichten sind weniger zur Strombegrenzung geeignet als hochdotierte p-n-Übergänge. Hingegen haben letztere aufgrund ihrer hohen Kapazität ein schlechtes Hochfrequenzverhalten.

Semiisolierende Schichten weisen den Nachteil auf, daß sie schon bei niedrigen Spannungen stromleitend werden. Es fließen daher Leckströme, wenn der Halbleiterlaser betrieben wird.

Es ist die Aufgabe der Erfindung, einen Halbleiterlaser zu schaffen, der ein sehr gutes Hochfrequenzverhalten aufweist und für die optische Hochgeschwindigkeitsübertragung geeignet ist.

Die Aufgabe wird bei einem gattungsgemäßen Halbleiterlaser dadurch gelöst, daß seitlich der laseraktiven Zone zusätzlich wenigstens eine n-leitende und eine p-leitende Schicht vorhanden sind, die übereinander liegen.

Der erfindungsgemäße Halbleiterlaser hat den Vorteil einer hohen Lichtausgangsleistung.

Die Erfindung wird anhand der Zeichnung nachfolgend in zwei Ausführungsbeispielen beschrieben. Es zeigen:

Fig. 1 den Querschnitt eines Halbleiterlasers mit einer semiisolierenden Schicht und

Fig. 2 den Querschnitt eines Halbleiterlasers mit zwei semiisolierenden Schichten.

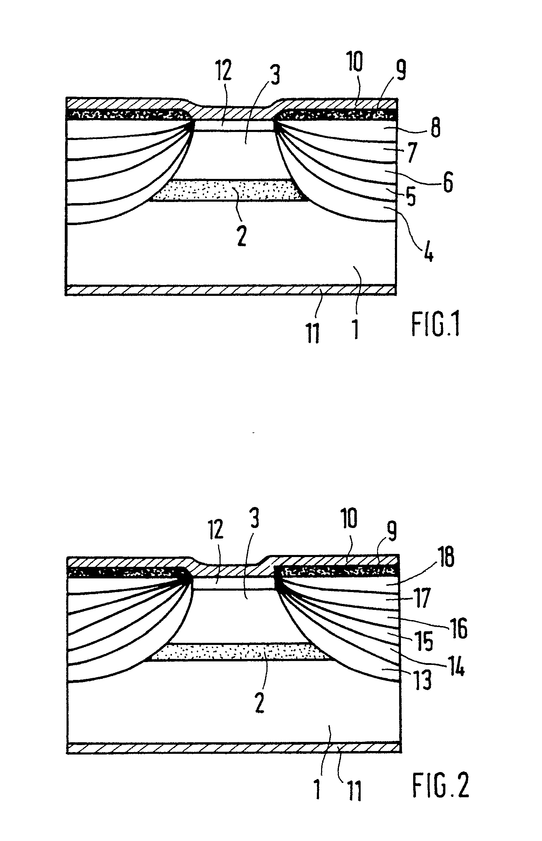

Ein Halbleiterlaser (Fig. 1) erstreckt sich auf einem Halbleitersubstrat 1. Das Halbleitermaterial ist entweder eine II-VI-Verbindung oder eine III-V-Verbindung, z.B. n-InP. Darüber befindet sich eine laseraktive Zone 2 aus InGaAsP, oberhalb deren sich eine Wellenleiterzone 3 aus p-InP und eine Kontaktschicht 12 aus p-InGaAsP befinden.

Die Schichten 2, 3, 12, bilden eine Mesa, die sich in Längsrichtung des Halbleiterlasersubstrats 1 erstreckt.

Seitlich der Mesa liegen mehrere Schichten aus InP, eine semiisolierende Schicht 4, eine p-leitende Schicht 5, eine n-leitende Schicht 6, eine p-leitende Schicht 7 und eine n-leitende Schicht 8 übereinander. Die Schicht 8 bildet mit der Kontaktschicht 12 eine gemeinsame, planare Oberfläche. Die Schicht 8 wird durch eine Schicht 9 aus Siliziumdioxid bedeckt; die Schichten 9 und 12 sind mit einer Metallschicht 10 überzogen, die als elektrischer Kontakt dient. Unterhalb des Halbleitersubstrats 1 ist eine Metallschicht 11 vorhanden, die ebenfalls als elektrischer Kontakt dient.

Ein anderer Halbleiterlaser (Fig. 2) weist ebenfalls Schichten 1 bis 3 sowie 9 bis 12 des Halbleiterlasers nach Fig. 1 auf.

Seitlich der Mesa befinden sich übereinander eine p-leitende Schicht 13, eine n-leitende Schicht 14, eine erste semiisolierende Schicht 15, eine weitere p-leitende Schicht 16, eine weitere n-leitende Schicht 17 und eine zweite semiisolierende Schicht 18.

Auch andere Schichtenfolgen der semiisolierenden bzw. n-und p-leitenden Schichten sind möglich. Sofern nur eine einzige semiisolierende Schicht vorhanden ist, kann sie sich sowohl unterhalb als auch oberhalb der n- und p-leitenden Schichten befinden.

Semiisolierende sowie n- und p-leitende Schichten, die seitlich einer laseraktiven Zone übereinander liegen, eignen sich sowohl für einen BH-Halbleiterlaser als auch für einen TJS (Transverse-Junction Stripe)-Halbleiterlaser und für einen CSP (Channeled Substrate Planar)-Halbleiterlaser.

## Ansprüche

1. Halbleiterlaser, der auf einem Halbleitersubstrat wenigstens eine, sich über einen Teil der Oberfläche des Halbleitersubstrats erstreckende laseraktive Zone und seitlich der laseraktiven Zone wenigstens eine semiisolierende Schicht aufweist,
**dadurch gekennzeichnet,**
daß seitlich der laseraktiven Zone (2) zusätzlich wenigstens eine n-leitende (6) und eine p-leitende Schicht (5) vorhanden sind, die übereinander liegen.

2. Halbleiterlaser nach Anspruch 1,
dadurch gekennzeichnet,
daß mehrere, jeweils übereinanderliegende n- und p-leitende Schichten (5, ..., 8) und eine einzige semiisolierende Schicht (4) vorhanden sind.

3. Halbleiterlaser nach Anspruch 2,
dadurch gekennzeichnet,
daß sich die n- und p-leitenden Schichten (5, ..., 8) unterhalb der semiisolierenden Schicht (4) befinden.

4. Halbleiterlaser nach Anspruch 1,
dadurch gekennzeichnet,
daß sich die n- und p-leitenden Schichten (5, ..., 8) oberhalb der semiisolierenden Schicht (4) befinden.

5. Halbleiterlaser nach Anspruch 1,
dadurch gekennzeichnet,
daß oberhalb der n- und p-leitenden Schichten (5, ..., 8) sowie der semiisolierenden Schicht (4) eine Schicht aus Siliziumdioxid (9) und daß oberhalb der Schicht aus Siliziumdioxid (9) und oberhalb der laseraktiven Zone (2) und unterhalb des Halbleitersubstrats (1) metallische Kontaktschichten (10, 11) vorhanden sind.

FIG.1

FIG.2